# EUROPEAN PATENT SPECIFICATION

(11) **EP 0 845 886 B1**
(45) Date of publication and mention of the grant of the patent: **04.01.2017**
(21) Application number: 97307996.5
(22) Date of filing: 09.10.1997
(51) Int. Cl.: H04H 60/04, H04L 25/05

(54) **Digital signal processing apparatus, such as a digital audio mixer**
Digitale Signalverarbeitungsvorrichtung, wie zum Beispiel ein digitales Tonmischpult
Dispositif de traitement numérique de signaux, comme par exemple un mélangeur numérique de son

(30) Priority: 27.11.1996 GB 9624702
(43) Date of publication of application: 03.06.1998
(73) Proprietor: SONY UNITED KINGDOM LIMITED, Weybridge, Surrey KT13 0XW (GB)
(72) Inventor: Eastty, Peter Charles, Oxford, OX4 1TE (GB); Sleight, Christopher, Chipping Norton, Oxon OX7 5AA (GB); Thorpe, Peter Damien, Oxford, Oxon OX1 4NY (GB)
(74) Representative: D Young & Co LLP

(56) References cited:
- DE-A- 3 613 475
- GB-A- 1 479 313

## Description

This invention relates to digital signal processing.

In a digital switching apparatus such as a digital audio mixer, when a switch (or "cut") is to occur from one digital audio signal to another, it is usual to apply the cut when the two signals are the same. Even though this leads to a delay between initiation and implementation of the cut, the requirement that both signals are the same reduces the magnitude of an audible "click" generated by the cut.

With a multibit PCM (pulse code modulated) audio signal, it is relatively straightforward to detect when the two signals are the same, simply by comparing the numerical values of corresponding PCM samples for the two signals.

For one-bit digital audio signals, an appropriate test is that the two one-bit signals are the same over a number of corresponding successive bits. However, if the requirement is that m bits are identical in the two signals, then statistically there will be an average delay of 2^{m} samples before this will occur. For example, if the requirement is that 14 bits are to be identical the average delay before this will next occur is about 5 milliseconds in a 64fs system¹. However, this delay period is not bounded.
¹Here, fs refers to an sampling rate of, for example, 44.1 kHz or 48 kHz. The one-bit digital audio signal in this example has a bit rate of 64fs, or 2.8224 or 3.072 MHz respectively.

So, this leads to two conflicting requirements for deciding when to implement a cut between the two signals. Although it is better to wait for a large number of corresponding bits in the two signals to be identical before implementing the cut, it is undesirable to impose a long delay after the cut control is operated before the cut takes effect.

Similar problems can occur when two one-bit audio signals having separate clocking sources are being processed by a single piece of equipment, it is normal that the two clocks will have slightly different frequencies, within the tolerances defined by the formats of the digital signals. This means that clocking differences (expressed in numbers of bits or numbers of clock cycles) will tend to build up between the two signals.

A certain number of such errors can be handled by an input buffer, but of course a buffer has only a limited size. So, the normal way of dealing with such errors is to drop or repeat samples from the input signal. This process is generally known as "clock slipping".

In order to reduce the audible effect of clock slipping, it is better to drop or repeat a sample when the input signal and itself displaced by the number of dropped or repeated samples are substantially identical over a number of consecutive samples.

For one-bit signals, if the requirement is that m bits are identical between the signal m and the displaced signal, then statistically there will be an average delay of 2ⁿ samples before this will occur. For example, if the requirement is that 14 bits are to be identical the average delay before this will next occur is about 5 milliseconds in a 64fs system.

During this time delay (which is not bounded) further clocking errors could build up to the extent that the buffer capacity can be exceeded However, if a very relaxed criterion is used to give a quicker response (e.g. a requirement that only a few bits must be identical) then the clock slipping operation can produce subjectively disturbing sounds (e.g. clicks) when samples are dropped or repeated

DE3613475 discloses a digital audio switching method that compares a current sample in a first signal with a current sample in a second signal and also compares the direction of change of the two signals. Switching is performed in dependence on these comparisons, with a potential extra comparison of whether both signals have a zero value.

Embodiments of the invention provide an apparatus according to claim 1.

In the invention, the two apparently conflicting requirements described above are both addressed.

When a cut or switching operation is initiated, the criterion for judging whether the two signals are sufficiently identical to execute the switching operation is made to be relatively severe, in that a large number of successive corresponding bits must be identical.

However, as time goes on, the criterion is progressively relaxed, so that fewer and fewer bits are required to be identical in the two signals.

In embodiments of the invention, eventually, at a predetermined time from initiation of the switching operation (e.g. 10 milliseconds), the requirement can be reduced so that only one bit of the two signals must be identical - a criterion which is fulfilled practically instantaneously.

This arrangement means that if the two signals are sufficiently identical, the cut will occur quickly and with a reduced click. However, in embodiments of the invention, an upper limit (in this case, 10 milliseconds) may be placed on the length of time which can occur before the cut is implemented.

Embodiments of the invention provides apparatus according to claim 4.

With the invention, and in particular these embodiments, the two apparently conflicting requirements described above are addressed.

When the current clocking error is relatively small (e.g. a small proportion of the buffer size) a severe criterion for clock slipping is imposed by requiring a large number of bits to be identical before one or more samples can be dropped or repeated.

However, as the number of samples of the clocking errors increases and the buffer size is used up, the criterion is progressively relaxed, so that fewer and fewer bits are required to be identical between the signal and the displaced signal. in embodiments of the invention, eventually, when the buffer is practically full, the requirement may simply be that one bit of the two signals must be identical - a criterion which is fulfilled practically instantaneously.

Embodiments of the invention will now be described, by way of example only, with reference to the accompanying drawings, throughout which like parts are referred to by like references, and in which:
Figure 1 is a schematic diagram of a one-bit digital switching apparatus; and
Figure 2 schematically illustrates a one-bit digital signal synchronisation apparatus.

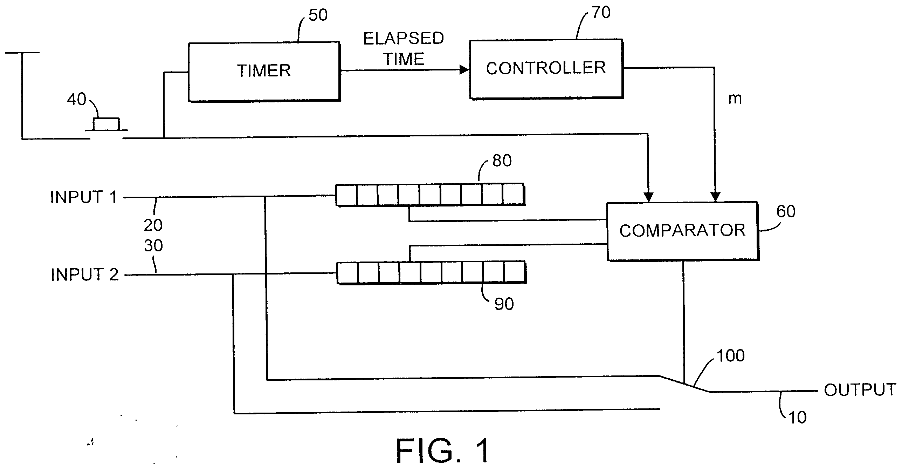

Referring to the drawings, Figure 1 is a schematic diagram of a one-bit digital switching apparatus for generating an output one-bit signal 10 by switching between a pair of input one-bit digital signals 20, 30.

The switch operation between the two input signals is initiated by a user pressing a control button 40, connected to a timer 50 and to a comparator 60. The output of the timer 50 is connected to a controller 70 which generates a control value m in response to a signal from the timer 50 indicative of the elapsed time since the control button 40 was pressed and the switch operation was initiated.

The two input signals 20,30 are supplied in parallel to shift register buffers 80,90 and to a switch 100 under control of the comparator 60.

The operation of the apparatus of Figure 1 is as follows. The comparator 60 controls the operation of the switch 100 to switch between the two input signals 20, 30. In order for the switch to take place, the comparator 60 requires that m bits of the two input signals 20, 30 (as stored in the shift register buffers 80, 90) are identical.

The control value m (the number of bits which must be identical) is set by the controller 70 in response to the elapsed time since the switching operation was initiated. When the switching operation is first initiated, the control value m is set to a relatively large number of bits, e.g. 20 bits. With time, the control value m is reduced progressively. For example, the value m could decrease in a linear relation to increasing elapsed time. At a predetermined time after the switching event was initiated, considered to be the maximum time for which the switching operation can be delayed, the control value m reaches a very low number such as one bit. (The requirement for one bit of each of the two input signals to be identical is met substantially instantaneously).

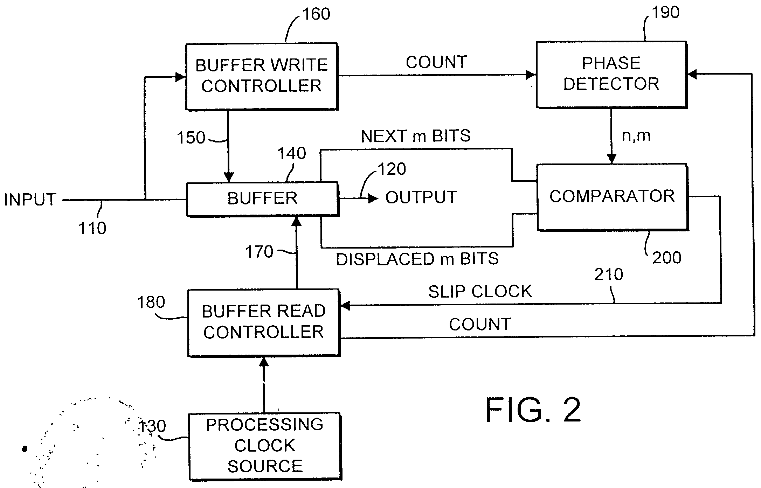

Referring to Figure 2, the apparatus shown might form an input stage of, for example, a digital audio mixing console or other audio processing device.

The apparatus of Figure 2 receives an input one-bit digital signal 110 and supplies an output one-bit digital signal 120. The input signal is clocked according to an input clock source and the output signal 120 is clocked according to a processing clock source 130 (which may be internal or external to the apparatus of Figure 2). Generally, the input clock source and the processing clock source are nominally the same bit rate, but deviate within the tolerances allowed by the particular digital signal transmission format in use.

The input signal is buffered in a buffer 140. This is the type of buffer where the position at which the next received input bit is to be written is controlled by a write pointer 150 (in turn controlled by a buffer write controller 160) and the position at which bits of the output signal are read from the buffer is similarly controlled by a read pointer 170 under the control of a buffer read controller 180. Basically, as each bit is written to the buffer 140, the write pointer 150 is advanced by one bit, and as each bit is read from the buffer 140, the read pointer 170 is advanced by one bit.

It is desirable to keep a certain amount of data in the buffer at any time. For example, for a total buffer size of, say, 100 bits, the system could be set up to aim for the buffer to hold perhaps 50 bits of the input signal at any time. This allows the buffer then to compensate for positive or negative clocking errors between the input and output clocks; if the input bits are received faster than they are required at the output, then more bits can be held in the buffer; conversely, if the output bits are required faster than they are received at the input, then the number of bits held in the buffer can be allowed to decrease. However, these are essentially temporary measures; to return the buffer to its desired occupancy it will generally be necessary to repeat or discard bits in the output signal - i.e. a clock slipping process.

A phase detector 190 receives respective count signals from the buffer write controller 160 and the buffer read controller 180. In this way, the phase detector 190 is able to detect any discrepancies between the rate at which bits are written into the buffer and the rate at which they are read from the buffer to form the output signal, given the overall aim of maintaining the desired occupancy level in the buffer.

If discrepancies are detected, the phase detector 190 generates an output value n, being the number of bits by which the input and output clock sources have become out of phase. The phase detector 190 also generates a control value m, to be discussed below.

The control values n and m are supplied to a comparator 200 which accesses the buffer 140 to compare the next m bits to be output with a group of m adjacent bits in the buffer, displaced from the next m bits for output by a displacement of n bits. The displaced group is displaced in a direction so that the phase discrepancy is reduced. So, if the input bits are received faster than they are required at the output, then bits are dropped to correct this discrepancy and vice versa.

If the two groups of m bits are detected to be identical, the comparator issues a slip clock signal 210 to instruct the buffer read controller 180 to move the position of the read pointer 170 so as to discard or repeat m bits in the output signal.

One example of the relationship between n and m is shown in the following table:

| n (number of clock errors) | m (number of bits required to be identical) |
|---|---|
| 1 - 3 | 15 |
| 4 - 7 | 13 |
| 8 - 10 | 11 |
| 11 - 15 | 9 |
| 16 - 20 | 7 |
| 21 - 25 | 5 |
| 26 - 30 | 3 |
| over 30 | 1 |

So, the value of m is lower for higher values of n.

In other embodiments, the number of bits "slipped" (n) need not be the same as the phase error between the input and output clocks. It could be smaller, in which case partial compensation could occur, or larger, in which case over compensation would occur. However, the relationship between the phase error and m, the number of bits required to be identical, would remain as described above.

Thus, embodiments of the invention provide apparatus for switching from one signal to another (in one case, a different signal, and in another case, a delayed or advanced version of the first signal), in which a test is applied to detect whether m consecutive bits of the two signals are the same, where the value m is varied in dependence on the urgency of the switch-over.

## Claims

1. One-bit digital switching apparatus for generating an output one-bit signal (10) by switching from a first (20) to a second (30) input one-bit signal after a desired switch time, the apparatus comprising:
means for supplying the first and second input one bit signals in parallel to respective shift register buffers (80, 90) and to switching means (100);
means (70) for setting a control value, m, to a predetermined initial value integer at the desired switch time;
means (60) for detecting whether corresponding m-bit sequences of the first and second one-bit signals currently held by the shift register buffers are identical, the detection continuing until the corresponding sequences are detected to be identical; means (50, 60, 70) for progressively decreasing the value of m with elapsed time since the desired switch time while the corresponding sequences have not been detected to be identical;
the switching means (100) being responsive to a detection that the corresponding m-bit sequences of the first and second one-bit signals are identical, for switching from the first to the second one-bit signals.

2. Apparatus according to claim 1, in which the value of m is decreased in a linear relation to elapsed time since the desired switching time.

3. Apparatus according to claim 1 or claim 2, in which the first and second one-bit digital signals are each one-bit digital audio signals.

4. Apparatus for synchronising the phase of a one-bit digital signal (110) having an input bit rate to the phase of an output clock (130) by discarding or repeating data bits of the one-bit signal to compensate for phase discrepancies between the input bit rate and the output clock, the apparatus comprising:
a buffer (140) for receiving bits of the one-bit signal and for outputting bits of the one-bit signal according to the output clock;
means (190) for detecting the number of bit periods of the output clocking signal by which the input bit rate is out of phase with the output clock;
means (190) for setting a control value, m, to an integer value dependent on the detected number of bit periods, so that m is lower for higher numbers of bit periods;
means for detecting whether a first m-bit sequence of the one-bit signal is identical with a corresponding m-bit sequence displaced by n bits with respect to the first m-bit sequence, the detection continuing until the corresponding sequences are detected to be identical; and
means (200) responsive to a detection that the corresponding m-bit sequences of the one-bit signal are identical, for discarding or repeating n bits on output (120) of the one-bit signal from the buffer by moving a read pointer of the buffer (140) in a direction to reduce the phase discrepancy between the input bit rate and the output clock.

5. Apparatus according to claim 4, in which n is equal to the number of bit periods by which the input bit rate is out of phase with the output clock.

6. Apparatus according to claim 4 or claim 5, in which the detecting means is operable to detect phase discrepancies by comparing respective count signals from a buffer write controller and a buffer read controller to detect discrepancies between the rate at which bits are written to the buffer and the rate at which bits are read from the buffer.

7. Apparatus according to any one of claims 4 to 6, in which the one-bit digital signal is a one-bit digital audio signal.

## Patentansprüche

1. Digitale Ein-Bit-Schaltvorrichtung zum Erzeugen eines Ein-Bit-Ausgangssignals (10) durch Schalten von einem ersten (20) zu einem zweiten (30) Ein-Bit-Eingangssignal nach einer gewünschten Schaltzeit, wobei die Vorrichtung Folgendes umfasst:
Mittel zum Zuführen des ersten und des zweiten Ein-Bit-Eingangssignals parallel zu jeweiligen Schieberegisterpuffern (80, 90) und zu Schaltmitteln (100) ;
Mittel (70) zum Einstellen eines Steuerwerts m auf einen vorbestimmten ganzzahligen Anfangswert zu der gewünschten Schaltzeit;
Mittel (60) zum Detektieren, ob entsprechende m-Bit-Folgen des ersten und des zweiten Ein-Bit-Signals, die aktuell durch die Schieberegisterpuffer gehalten sind, identisch sind, und Fortsetzen der Detektion, bis detektiert wird, dass die entsprechenden Folgen identisch sind; Mittel (50, 60, 70) zum schrittweisen Verringern des Werts von m mit der vergangenen Zeit seit der gewünschten Schaltzeit, während nicht detektiert worden ist, dass die entsprechenden Folgen identisch sind;
wobei die Schaltmittel (100) auf eine Detektion, dass die entsprechenden m-Bit-Folgen des ersten und des zweiten Ein-Bit-Signals identisch sind, zum Schalten von dem ersten zu dem zweiten Ein-Bit-Signal reagieren.

2. Vorrichtung nach Anspruch 1, wobei der Wert von m in einer linearen Relation zu der vergangenen Zeit seit der gewünschten Schaltzeit verringert wird.

3. Vorrichtung nach Anspruch 1 oder Anspruch 2, wobei das erste und das zweite Ein-Bit-Signal jeweils digitale Ein-Bit-Audiosignale sind.

4. Vorrichtung zum Synchronisieren der Phase eines digitalen Ein-Bit-Signals (110), das eine Eingabebitrate aufweist, mit der Phase eines Ausgabetakts (130) durch Verwerfen oder Wiederholen von Datenbits des Ein-Bit-Signals, um die Phasenabweichungen zwischen der Eingabebitrate und dem Ausgabetakt zu kompensieren, wobei die Vorrichtung Folgendes umfasst:
einen Puffer (140) zum Aufnehmen von Bits des Ein-Bit-Signals und zum Ausgeben von Bits des Ein-Bit-Signals gemäß dem Ausgabetakt;
Mittel (190) zum Detektieren der Anzahl von Bitperioden des Ausgabetaktungssignals, um die die Eingabebitrate mit dem Ausgabetakt außer Phase ist;
Mittel (190) zum Einstellen eines Steuerwerts, m, auf einen Ganzzahlwert abhängig von der detektierten Anzahl von Bitperioden, so dass m für eine größere Anzahl von Bitperioden niedriger ist;
Mittel zum Detektieren, ob eine erste m-Bit-Folge des Ein-Bit-Signals identisch ist mit einer entsprechenden m-Bit-Folge verschoben um n Bits in Bezug auf die erste m-Bit-Folge, und Fortsetzen der Detektion, bis detektiert wird, dass die entsprechenden Folgen identisch sind; und
Mittel (200) zum Verwerfen oder Wiederholen von n Bits auf der Ausgabe (120) des Ein-Bit-Signals aus dem Puffer in Reaktion auf eine Detektion, dass die entsprechenden m-Bit-Folgen des Ein-Bit-Signals identisch sind, durch Bewegen eines Zeigers des Puffers (140) in eine Richtung, um die Phasenabweichung zwischen der Eingabebitrate und dem Ausgabetakt zu reduzieren.

5. Vorrichtung nach Anspruch 4, wobei n gleich der Anzahl von Bitperioden ist, um die die Eingabebitrate mit dem Ausgabetakt außer Phase ist.

6. Vorrichtung nach Anspruch 4 oder Anspruch 5, wobei die Detektionsmittel arbeiten, um Phasenabweichungen durch Vergleichen jeweiliger Zählsignale aus einer Pufferschreibsteuereinheit und einer Pufferlesesteuereinheit zu detektieren, um Abweichungen zwischen der Rate, mit der Bits in den Puffer geschrieben werden, und der Rate, mit der Bis aus dem Puffer gelesen werden, zu detektieren.

7. Vorrichtung nach einem der Ansprüche 4 bis 6, wobei das digitale Ein-Bit-Signal ein digitales Ein-Bit-Audiosignal ist.

## Revendications

1. Appareil de commutation numérique sur un bit destiné à générer un signal de sortie sur un bit (10) en basculant d'un premier (20) sur un second (30) signal d'entrée sur un bit après un temps souhaité de commutation, l'appareil comprenant:
un moyen permettant de délivrer en parallèle les premier et second signaux d'entrée sur un bit à des mémoires tampon (80, 90) respectives à registres à décalage et au moyen de commutation (100),
un moyen (70) permettant de régler une valeur de commande, m, à une valeur entière initiale prédéterminée à l'instant souhaité de basculement,
un moyen (60) permettant de détecter si des séquences sur m bits correspondantes des premier et second signaux d'entrée sur un bit détenus au moment par les mémoires tampon à registres à décalage sont identiques, la détection se poursuivant jusqu'à ce que les séquences correspondantes soient détectées comme étant identiques ; un moyen (50, 60, 70) permettant de diminuer progressivement la valeur de m avec le temps écoulé depuis l'instant souhaité de commutation alors que les séquences correspondantes n'ont pas été détectées comme étant identiques,
le moyen de commutation (100) étant sensible à une détection de ce que les séquences correspondantes sur m bits des premier et second signaux d'entrée sur un bit sont identiques, dans le but de réaliser un basculement du premier vers le second signal sur un bit.

2. Appareil selon la revendication 1, dans lequel la valeur m diminue selon une relation linéaire avec le temps écoulé depuis l'instant souhaité de commutation.

3. Appareil selon la revendication 1 ou la revendication 2, dans lequel les premier et second signaux d'entrée sur un bit sont chacun des signaux audio numériques sur un bit.

4. Appareil de synchronisation de la phase d'un signal numérique sur un bit (110) présentant un débit binaire d'entrée sur la phase d'une horloge de sortie (130) en rejetant ou en répétant des bits de données du signal sur un bit pour compenser des divergences de phase entre le débit binaire d'entrée et l'horloge de sortie, l'appareil comprenant :
une mémoire tampon (140) destinée à recevoir des bits du signal sur un bit et à délivrer en sortie des bits du signal sur un bit en fonction de l'horloge de sortie,
un moyen (190) destiné à détecter le nombre de périodes binaires du signal d'horloge de sortie desquelles le débit binaire d'entrée est déphasé avec l'horloge de sortie,
un moyen (190) destiné à régler une valeur de commande, m, à une valeur entière qui dépend du nombre détecté de périodes binaires de sorte à ce que m soit inférieur pour des nombres plus grands de périodes binaires,
un moyen destiné à détecter si une première séquence sur m bits du signal sur un bit est identique à une séquence correspondante sur m bits décalée de n bits par rapport à la première séquence sur m bits, la détection se poursuivant jusqu'à ce que les séquences correspondantes soient détectées être identiques, et
un moyen (200) sensible à la détection de ce que les séquences correspondantes sur m bits du signal sur un bit sont identiques, dans le but de rejeter ou de répéter n bits sur la sortie (120) du signal sur un bit à partir de la mémoire tampon en déplaçant un pointeur de lecture de la mémoire tampon (140) dans une direction permettant de réduire la divergence de phase entre le débit binaire d'entrée et l'horloge de sortie.

5. Appareil selon la revendication 4, dans lequel n est égal au nombre de périodes binaires duquel le débit binaire d'entrée est déphasé de l'horloge de sortie.

6. Appareil selon la revendication 4 ou la revendication 5, dans lequel le moyen de détection peut être mis en oeuvre pour détecter des divergences de phase en comparant des signaux respectifs de comptage à partir d'un contrôleur d'écriture en mémoire tampon et d'un contrôleur de lecture en mémoire tampon afin de détecter les divergences entre le débit avec lequel les bits sont écrits dans la mémoire tampon et le débit avec lequel les bits sont lus de la mémoire tampon.

7. Appareil selon l'une quelconque des revendications 4 à 6 dans lequel le signal numérique sur un bit est un signal audio numérique sur un bit.
